# EUROPÄISCHE PATENTSCHRIFT

(11) **EP 0 350 815 B1**
(45) Veröffentlichungstag und Bekanntmachung des Hinweises auf die Patenterteilung: **20.10.1993**
(21) Anmeldenummer: 89112494.3
(22) Anmeldetag: 07.07.1989
(51) Int. Cl.: H01J 37/256, G01N 23/225

(54) **Verfahren zum Betrieb eines Sekundärionen-Massenspektrometers**
Process to operate a secondary ion mass spectrometer
Procédé pour opérer un spectromètre de masse à ions secondaires

(30) Priorität: 14.07.1988 DE 3823912
(43) Veröffentlichungstag der Anmeldung: 17.01.1990
(73) Patentinhaber: SIEMENS AKTIENGESELLSCHAFT, 80333 München (DE)
(72) Erfinder: von Criegern, Rolf, Dipl.-Phys., D-8192 Geretsried 1 (DE)

(56) Entgegenhaltungen:
- EP-A- 0 143 146
- FR-A- 2 605 739
- JOURNAL OF VACUUM SCIENCE & TECHNOLOGY PART A, Band 5, Nr. 4, Teil II, Juli/August 1987, Seiten 1247-1249, American Vacuum Society, New York, US; C. SCHOLZE et al.: "New data system for depth profiling of inhomogeneous samples by secondary ion mass spectrometry"

## Beschreibung

Die Erfindung bezieht sich auf ein Verfahren zum Betrieb eines Sekundärionen-Massenspektrometers.

In einem Sekundärionen-Massenspektrometer wird der "dynamische Bereich" einer Tiefenprofilmessung und damit auch die niedrigste noch erfaßbare Elementkonzentration häufig durch die Signalbeiträge der am Rand des Sputterkraters und dessen Umgebung ausgelosten Sekundärionen begrenzt. Besonders störend wirken sich diese sogenannten Kraterrandeffekte bei der Messung des Tiefenprofils eines Dotierstoffes in einem Halbleitersubstrat aus, wo die Dotierstoffkonzentration in einigen 100 nm Tiefe um mehr als 5 bis 6 Größenordnungen niedriger ist als an der Oberfläche.

In konventionellen Sekundärionen-Massenspektrometern werden deshalb sogenannte Gating-Techniken (elektronisches bzw. ionenoptisches Gating) angewandt, um die Signalbeiträge der am Kraterrand und den angrenzenden Bereichen vom primären Ionenstrahl und dessen weitreichenden Ausläufern abgesputterten Sekundärionen auf ein Minimum zu reduzieren (s. beispielsweise A. Benninghoven; Secondary Ion Mass Spectrometry, Chemical Analysis, Vol. 86 (1987), Seiten 518 bis 520 und Seiten 792 bis 805).

Bedingt durch den von der Masse, der Energie und der Ladung der abgesputterten Sekundärionen abhängigen Laufzeiteffekt, besitzen die auf der Gating-Technik beruhenden Meßverfahren allerdings nur dann eine hohe Ortsauflösung, wenn man den primären Ionenstrahl mit einer vergleichsweise niedrigen Abtastgeschwindigkeit über die Probenoberfläche führt. In der der FR-A-2 605 739 entsprechenden DE-A-36 36 506 wird daher vorgeschlagen, den Einfluß des statistischen Schwankungen unterworfenen Laufzeiteffekts durch eine spiralförmige Ablenkung des primären Ionenstrahls innerhalb des zu untersuchenden Oberflächenbereichs weitgehend zu unterdrücken (s. auch J. Vac. Sci. Technol. A 5(4), 1987, S. 1247 - 1249). Infolge der spiralförmigen Ablenkung bewegt sich der primäre Ionenstrahl dann während der Messung nahezu ausschließlich innerhalb des durch ein elektronisches Zeitfenster definierten Oberflächenbereichs, wo der Laufzeiteffekt zwar weiterhin vorhanden ist, aber keine die Ablenkgeschwindigkeit begrenzenden Wirkungen mehr entfaltet.

Kraterrandeffekte lassen sich auch durch eine geeignete Präparation und Halterung der Probe weitgehend unterdrücken. So wird in der US-A-4 465 935 vorgeschlagen, die nicht zu analysierenden Teile der Probe vor der Messung zu entfernen und den verbleibenden Teil umgebungsfrei im Ionenstrahl anzuordnen.

Die EP-A-0 143 146 beschreibt ein Ionenstrahlverfahren, bei dem man die aus quadratischen Teilflächen des Sputterkraters stammenden Zählraten zu einem Meßwert aufsummiert und diesen an einem der jeweiligen Teilfläche zugeordneten Speicherplatz ablegt. Kraterrandeffekte lassen sich weitgehend ausschalten, wenn bei der Auswertung nur die den inneren Teilflächen des Sputterkraters zugeordneten Meßwerte berücksichtigt werden.

Der Erfindung liegt die Aufgabe zugrunde, ein Verfahren zum Betrieb eines Sekundärionen-Massenspektrometers anzugeben, mit dem der nutzbare dynamische Bereich einer Tiefenprofilmessung ohne zusätzliche elektronische oder ionenoptische Maßnahmen deutlich erweitert werden kann.

Diese Aufgabe wird erfindungsgemäß durch ein Verfahren nach Patentanspruch 1 gelöst. Die Unteransprüche betreffen vorteilhafte Weiterbildungen der Erfindung.

Der mit der Erfindung erzielbare Vorteil besteht insbesondere darin, daß Kraterrandeffekte ohne präparativen Aufwand außerhalb des Sekundärionen-Massenspektrometers nahezu vollständig unterdrückt werden können.

Die Erfindung wird im folgenden anhand der Zeichnungen näher erläutert. Hierbei zeigt:
- Figur 1: den schematischen Aufbau eines Sekundärionen-Massenspektrometers,
- Figur 2: die Abtastbewegung des Ionenstrahls auf der Oberfläche eines Halbleitersubstrats,
- Figur 3: die durch den abtastenden Ionenstrahl erzeugte Vertiefung ,
- Figur 4: das Profil des auf dem Halbleitersubstrat erzeugten Sputterkraters.

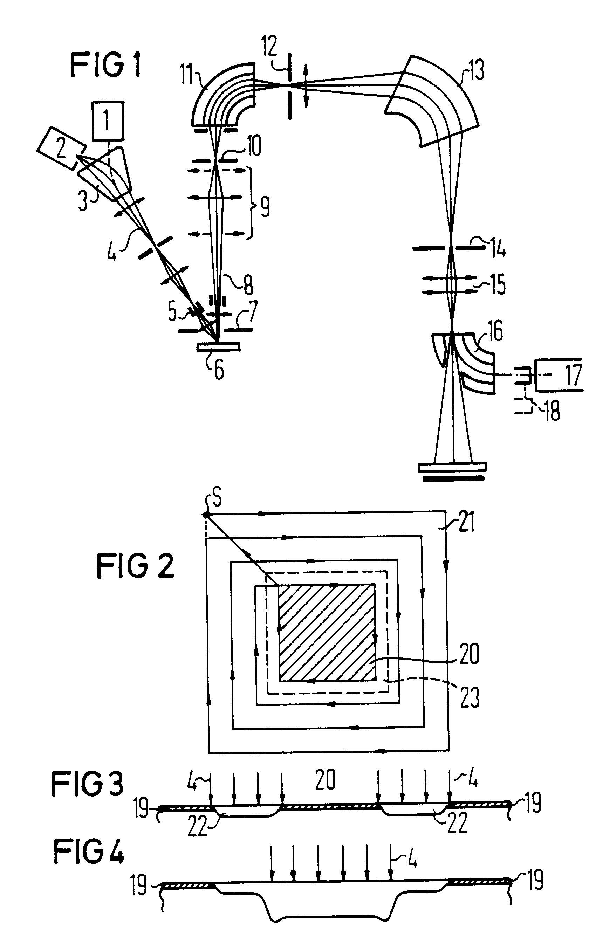

Das schematisch in Figur 1 dargestellte Sekundärionen-Massenspektrometer besteht aus einem Primärteil zur Erzeugung eines die Probe 6 flächenhaft abtastenden Ionenstrahls 4 und einem Sekundärteil, in dem die auf der Probe 6 ausgelösten Sekundärionen 8 nach ihrem Masse/Ladungsverhältnis getrennt und nachgewiesen werden. Der Primärteil umfaßt zwei Ionenquellen 1 und 2, einen Umlenkmagneten 3, eine von einem digitalen Rastergenerator angesteuerte Ablenkeinheit 5 und eine aus mehreren Linsen bestehende Ionenoptik, die die Austrittsöffnungen der Ionenquellen 1 bzw. 2 verkleinert auf die Probe 6 abbildet. Infolge der Abtastung der Probe 6 mit dem Ionenstrahl 4 wird deren Oberflächenmaterial schichtweise abgetragen (Prozeß der Ionenzerstäubung), so daß sich ein Sputterkrater mit einem annähernd ebenen Boden bildet. Zur Überführung der im Sputterkrater ausgelösten Sekundärionen 8 in den Sekundärteil der Anordnung ist eine eine elektrostatische Linse 7 (Immersionslinse) und mehrere Transferlinsen 9 umfassende Ionenoptik vorgesehen, die die Sekundärionenquelle in die Eintrittsöffnung 10 des im wesentlichen aus einem elektrostatischen Sektorfeld 11, einem energieselektierenden Spalt 12, einem Sektorfeldmagneten 13 und einem massenselektierenden Spalt 14 bestehenden Massenspektrometers abbildet. Die nach ihrem Masse/Ladungsverhältnis getrennten Sekundärionen 8 durchlaufen anschließend ein weiteres Linsenpaar 15 und einen Ablenkkondensator 16, um in einem Detektor, insbesondere einem Sekundärelektronenvervielfacher 17 oder einem Faraday-Becher 18, nachgewiesen zu werden.

Zur Aufzeichnung des Tiefenprofils eines Dotierstoffes in einem Halbleitersubstrat wird erfindungsgemäß vorgeschlagen, die eine hohe Dotierstoffkonzentration aufweisende Oberflächenschicht 19 in der Umgebung der späteren Meßfläche 20 mit dem Ionenstrahl 4 abzutragen. Dieser wird deshalb vor Beginn der Messung solange über den in Figur 2 mit 21 bezeichneten Bereich des Halbleitersubstrats geführt, bis sich innerhalb dieser die quadratische oder rechteckige Meßfläche 20 rahmenförmig umschließende Zone eine Vertiefung 22 von beispielsweise 50 bis 100 nm gebildet hat (siehe Figur 3). Um eine gleichmäßige Abtragung der hochdotierten Oberflächenschicht 19 zu gewährleisten, ist es von Vorteil, den Ionenstrahl in Form einer digitalen Spirale (siehe beispielsweise das eingangs erwähnte Lehrbuch Secondary Ion Mass Spectrometry, Seite 516 bis 517 insbesondere Figur 4.87d) innerhalb des ringförmigen Bereichs 21 abzulenken, wobei der Ionenstrahl 4 beim Erreichen der Meßfläche 20 zum Startpunkt S zurückspringt. Eine solche Ablenkbewegung läßt sich in einem mit einem digitalen Rastergenerator ausgestatteten Sekundärionen-Massenspektrometer ohne weiteres realisieren.

Mit dem Beginn der Tiefenprofilmessung wird auch die das Meßsignal erzeugende Elektronik aktiviert, wobei der Ionenstrahl 4 nun das in Figur 2 mit 23 bezeichnete Abtastfeld zeilenweise überstreicht. Dieses ebenfalls quadratische bzw. rechteckförmige Abtastfeld 23 überdeckt die Meßfläche 20 vollständig, um eine Gratbildung in deren Randbereichen zu vermeiden. Auf dem Halbleitersubstrat entsteht somit während der Messung ein Sputterkrater, dessen Profil schematisch in Figur 4 dargestellt ist. Infolge der Überlappung der Abtastbereiche 21 und 23 liegt der Kraterboden hierbei in der Mitte etwas höher als am Kraterrand.

Da die Ausläufer des Ionenstrahls 4 in der Umgebung des Kraterrandes nur noch Halbleiterschichten mit einer vergleichsweise niedrigen Dotierstoffkonzentration erreichen, erzielt man mit dem erfindungsgemäßen Verfahren insbesondere bei Anwendung der eingangs erwähnten elektronischen bzw. ionenoptischen Gating-Techniken eine Meßgenauigkeit, die etwa der des aus der US-A-4 465 935 bekannten Verfahrens entspricht. Hierbei ist allerdings keine spezielle Präparation und Halterung der untersuchten Probe 6 notwendig. Außerdem kann das erfindungsgemäße Verfahren ohne weiteres in allen mit einem digitalen Rastergenerator ausgestatteten Sekundärionen-Massenspektrometern durchgeführt werden.

Die Erfindung ist selbstverständlich nicht auf die beschriebenen Ausführungsbeispiele beschränkt. So ist es ohne weiteres möglich, den Ionenstrahl 4 auch zeilenförmig über den die Meßfläche 20 umschließenden Bereich 21 abzulenken. Die Ansteuerung der Ablenkeinheit gestaltet sich dann allerdings schwieriger.

Das erfindungsgemäße Verfahren ist bei allen Untersuchungen mit Sekundärionen-Massenspektrometern anwendbar, bei denen Kraterrandeffekte ausgeschaltet oder weitgehend unterdrückt werden müssen.

## Patentansprüche

1. Verfahren zum Betrieb eines Sekundärionen-Massenspektrometers, das eine Ionenquelle (1, 2), ein Linsensystem zur Erzeugung eines Ionenstrahls (4), eine Ablenkeinheit (5), ein Massenspektrometer (11, 12, 13, 14) und einen Detektor (17, 18) zum Nachweis der auf einer Probe (6) ausgelosten Sekundärionen (8) aufweist, umfassend die Schritte,
- daß der Ionenstrahl (4) über die Probenoberfläche geführt und eine eine Meßfläche (20) entlang des gesamten Randes der Meßfläche (20) unmittelbar und vollständig umschließende grabenförmige Vertiefung (22) erzeugt wird,
- daß der Ionenstrahl (4) anschließend innerhalb eines Abtastfeldes (23) abgelenkt wird, wobei das Abtastfeld (23) die Meßfläche (20) enthält und entlang des gesamten Randes der Meßfläche (20) einen Teil der grabenförmigen Vertiefung (22) überlappt und dabei innerhalb des aus der Meßfläche (20) und der grabenförmigen Vertiefung (22) bestehenden Probenbereichs (21) liegt, und
- daß die innerhalb des Abtastfeldes (23) ausgelösten Sekundärionen (8) registriert werden, um hieraus ein Meßsignal abzuleiten.

2. Verfahren nach Anspruch 1,
**dadurch gekennzeichnet,**
daß die grabenförmige Vertiefung (22) die Meßfläche (20) rahmenförmig umschließt.

3. Verfahren nach Anspruch 1 oder 2,
**dadurch gekennzeichnet,**
daß der Ionenstrahl (4) zur Erzeugung der grabenförmigen Vertiefung (22) spiralförmig über die Probenoberfläche geführt wird.

4. Verfahren nach einem der Ansprüche 1 bis 3,
**dadurch gekennzeichnet,**
daß die Meßfläche (20) und das Abtastfeld (23) jeweils die Form eines Rechteckes aufweisen.

5. Verfahren nach einem der Ansprüche 1 bis 3,
**dadurch gekennzeichnet,**
daß die Meßfläche (20) und das Abtastfeld (23) jeweils die Form eines Quadrates aufweisen.

## Claims

1. Process for operating a secondary ion mass spectrometer which exhibits an ion source (1, 2), a lens system for generating an ion beam (4), a deflecting unit (5), a mass spectrometer (11, 12, 13, 14) and a detector (17, 18) to detect the secondary ions (8) emitted on a specimen (6), comprising the steps in which:
- the ion beam (4) is guided over the specimen surface and a trench-shaped depression (22) directly and completely enclosing a measurement surface (20) along the entire boundary of the measurement surface (20) is generated,
- the ion beam (4) is subsequently deflected within a scanning field (23), the scanning field (23) containing the measurement surface (20) and overlapping a part of the trench-shaped depression (22) along the entire boundary of the measurement surface (20) and lying in this case within the specimen region (21) comprising the measurement surface (20) and the trench-shaped depression (22), and
- the secondary ions (8) emitted within the scanning field (23) are recorded, in order to derive a measurement signal from the same.

2. Process according to Claim 1, characterised in that the trench-shaped depression (22) encloses the measurement surface (20) in the manner of a frame.

3. Process according to Claim 1 or 2, characterised in that to generate the trench-shaped depression (22) the ion beam (4) is guided in a spiral shape over the specimen surface.

4. Process according to one of Claims 1 to 3, characterised in that the measurement surface (20) and the scanning field (23) each exhibit the shape of a rectangle.

5. Process according to one of Claims 1 to 3, characterised in that the measurement surface (20) and the scanning field (23) each exhibit the shape of a square.

## Revendications

1. Procédé pour faire fonctionner un spectromètre de masse à ions secondaires, qui comporte une source d'ions (1,2), un système de lentilles pour produire un faisceau d'ions (4), un déflecteur (5), un spectromètre de masse (11, 12,13,14) et un détecteur (17,18) de détection des ions secondaires (8) libérés sur un échantillon (6), le procédé consistant
- à envoyer le faisceau d'ions (4) sur la surface de l'échantillon et à produire une cavité (22) en forme de fosse entourant entièrement une surface à mesurer (20) et s'étendant directement le long de tout le bord de la surface à mesurer (20),
- à dévier ensuite le faisceau d'ions (4) dans un champ d'exploration (23), le champ d'exploration (23) contenant la surface à mesurer (20) et recouvrant, le long de tout le bord de la surface à mesurer (20), une partie de la cavité (20) en forme de fosse, et se trouvant ainsi à l'intérieur de la partie de l'échantillon (21) constituée de la surface à mesurer (20) et de la cavité (22) en forme de fosse, et
- à enregistrer les ions secondaires (8) libérés dans le champ d'exploration (23) pour en déduire un signal de mesure.

2. Procédé suivant la revendication 1,
caractérisé
en ce que la cavité (22) en forme de fosse entoure à la manière d'un cadre la surface à mesurer (20).

3. Procédé suivant la revendication 1 ou 2,
caractérisé
en ce que le faisceau d'ions (4) est envoyé, pour produire la cavité (22) en forme de fosse, en spirale sur la surface de l'échantillon.

4. Procédé suivant la revendication 1 à 3,
caractérisé
en ce que la surface à mesurer (20) et le champ d'exploration (23) ont chacun la forme d'un rectangle.

5. Procédé suivant la revendication 1 à 3,
caractérisé
en ce que la surface à mesurer (20) et le champ d'exploration (23) ont chacun la forme d'un carré.
